# EUROPÄISCHE PATENTSCHRIFT

(11) **EP 2 547 844 B1**
(45) Veröffentlichungstag und Bekanntmachung des Hinweises auf die Patenterteilung: **04.03.2015**
(21) Anmeldenummer: 11717450.8
(22) Anmeldetag: 11.03.2011
(51) Int. Cl.: E05B 17/22, E05B 65/10, H01H 3/14

(54) **PANIKTÜR**
PANIC DOOR
PORTE DE SECOURS

(30) Priorität: 18.03.2010 AT 4442010
(43) Veröffentlichungstag der Anmeldung: 23.01.2013
(73) Patentinhaber: Degelsegger, Walter, 4693 Desselbrunn (AT)
(72) Erfinder: Degelsegger, Walter, 4693 Desselbrunn (AT)
(86) Internationale Anmeldenummer: PCT/AT2011/000125
(87) Internationale Veröffentlichungsnummer: WO 2011/113075

(56) Entgegenhaltungen:
- DE-A1- 19 625 237
- GB-A- 2 316 537
- US-A1- 2010 045 053
- US-B1- 6 433 292

## Beschreibung

Die Erfindung betrifft eine als Drehflügeltür ausgeführte Paniktür.

Paniktüren müssen auch in einer Paniksituation ein sicheres Entkommen aus einem Gebäude ermöglichen. Eine Paniktür muss in Fluchtrichtung ohne Notwendigkeit eines Schlüssels und/oder irgendwelcher Vorkenntnisse problemlos zu öffnen sein. Da man sie oft als Notausgangstür verwendet, welche gegen Zutritt von außen her abgesperrt ist, kann man nicht einfach eine riegellose Schwingtür dafür verwenden.

In Normalfall verwendet man als Paniktür eine Drehtür, welche in Fluchtrichtung aufschwenkbar ist, wobei an jener Seite der Tür an welche man bei Flucht gelangt, eine u. a. "Panikbalken", "Panik-stange", "Panikleiste", "Sensorgriffleiste", "Sensorleiste", "Schalterleiste" genannte Vorrichtung angebracht ist. In allen Fällen handelt es sich dabei um einen horizontal quer über weitgehend das gesamte Türblatt verlaufenden Griffteil, welcher für das Öffnen der Tür auf das Türblatt zu gedrückt und bewegt werden muss um die Tür zu öffnen.

Von einem "Panikbalken" oder eine "Panikstange" spricht man eher, wenn die Bewegung dieses Griffteils auf das Türblatt zu durch eine ausschließlich mechanische Übersetzung in einen Bewegung des Riegels bzw. der Riegel übersetzt wird, durch welche die Tür entriegelt wird. Ein Beispiel für eine derartige Bauweise ist in der EP 2 112 305 A1 gezeigt. Vorteilhaft an den rein mechanischen Übersetzungen ist, dass sie energieautark funktionieren. Nachteilig ist, dass der "Panikbalken" recht robust ausgeführt sein muss und relativ weit vom Türblatt abstehen muss da er aus Übersetzungsgründen für das zuverlässige Bewegen der Riegel, selbst relativ weit auf das Türblatt zu bewegbar sein muss. Derartige "Panikbalken" stören daher oft optisch und sie können im Fall von Massenpanik im Gedränge auch zu Verletzungen führen.

Sehr häufig verwendet man den quer über das Türblatt verlaufenden Griffteil nur als den beweglichen Teil eines elektrischen Schalters. Wenn auf diesen Teil Druck ausgeübt wird, wird ein Stromkreis geschlossen und entweder direkt dadurch oder über eine Steuerung und einen durch diese geschalteten Stromkreis, werden ein oder mehrere elektrisch antreibbare Riegel in die geöffnete Stellung bewegt. Bei derartigen Funktionsweisen kann der quer über das Türblatt verlaufende Griffteil schlanker ausgeführt sein und braucht weniger vom Türblatt abzustehen. Man spricht dann von "Panikleiste", "Sensorgriffleiste", "Sensorleiste", "Schalterleiste". Beispiele dafür sind in den Schriften DE 10 011 763 A1, DE 19 625 237 C2, DE 19 953 765 A1, DE 9 314 870 U1, EP 1 065 577 B1, EP 1 072 743 A1, GB 2 323 405 A, US 2002 153 732 A1 und US 2005 237 214 A1 gezeigt.

Bei all diesen Ausführungsformen verläuft horizontal über das Türblatt, normal von der Ebene des Türblattes vorstehend, ein starrer Körper, welcher zum Türblatt in einem Abstand gehalten wird und auf dieses zu entgegen der Wirkung einer Feder zumindest einige Millimeter geführt beweglich ist. Wenn dieser starre Körper ausreichend stark gegen das Türblatt gedrückt wird, wird die beschriebene Schaltfunktion ausgelöst. Gegenüber der zuvor beschriebenen Bauweise sind damit zwar schlankere, weniger stark abstehende Bauweisen realisierbar. Die optische Störung und die Verletzungsgefahr bei Gedränge sind vermindert aber noch nennenswert vorhanden.

Die WO 9300480 A1 zeigt eine Tür, bei welcher an den Berührungsstellen zwischen Rahmen und Blatt ein oder mehrere Kraftsensoren angebracht sind. Wenn die Kraft mit der gegen das Türblatt gedrückt wird einen bestimmten Schwellwert über eine gewisse Mindestzeit überschreitet, wird durch eine Steuerung elektrisch oder pneumatisch die Tür entriegelt oder überhaupt schon geöffnet. Damit lässt sich der störende, horizontal über das Türblatt verlaufende Griffteil gänzlich vermeiden. Kaum behebbare Nachteile ergeben sich aber bezüglich der Sperrwirkung gegen Eintritt entgegen der Fluchtrichtung. Da die Kraft zwischen Türblatt und Türrahmen zum Auslösen des Entriegelns führt, kann die Tür auch von der Außenseite her geöffnet werden, beispielsweise unter Anwendung eines Sauggreifers.

Von diesem Stand der Technik ausgehend hat sich der Erfinder die Aufgabe gestellt, eine als Drehflügeltür ausgeführte Paniktür bereitzustellen, welche durch eine in Fluchtrichtung wirkende Druckkraft auf das Türblatt entriegelbar ist, wobei die Entriegelung unabhängig von den zwischen Türblatt und Türrahmen wirkenden Kräften funktionieren muss und wobei keine starren Teile in gefährdender Weise vom Türblatt vorzustehen brauchen.

Zum Lösen der Aufgabe wird von einer Bauweise ausgegangen, bei welcher der Riegel maschinell angetriebenen aus der gesperrten Stellung heraus bewegbar ist, wobei diese Bewegung durch einen Sensor ausgelöst wird, durch welchen detektiert wird, dass auf jene Seite des Türblattes eine Druckkraft ausgeübt wird, welche beim Aufschwenken des Türblatts hinten liegt.

Erfindungsgemäß wird vorgeschlagen, als Sensor eine druck- und/oder berührungsempfindliche Folie (des weiteren kurz "Sensorfolie" genannt) zu verwenden, welche bei Druck und/oder Berührung eine elektrisches Signal generiert und etwa in der Höhe, an welcher ansonsten ein "Panikbalken" anzuordnen wäre, angebracht ist. Eine derartige Folie trägt - wenn überhaupt - so wenig auf das Türblatt auf, dass sie keinerlei Verletzungsgefahr für Menschen mehr darstellt. Sie lässt sich, wenn nötig durch die Farbe eines Anstriches oder einer dünnen Oberflächenbeschichtung auch optisch entweder weitgehend verbergen oder in gewünschter Weise vorteilhaft darstellen.

Die Erfindung wird an Hand einer Zeichnung veranschaulicht:
- Fig. 1:: zeigt das Türblatt einer beispielhaften erfindungsgemäßen Tür in perspektivischer Ansicht.
- Fig. 2:: zeigt einen beispielhaften elektromechanischen Antrieb, welcher vorteilhaft an einer erfindungsgemäßen Tür einsetzbar ist.

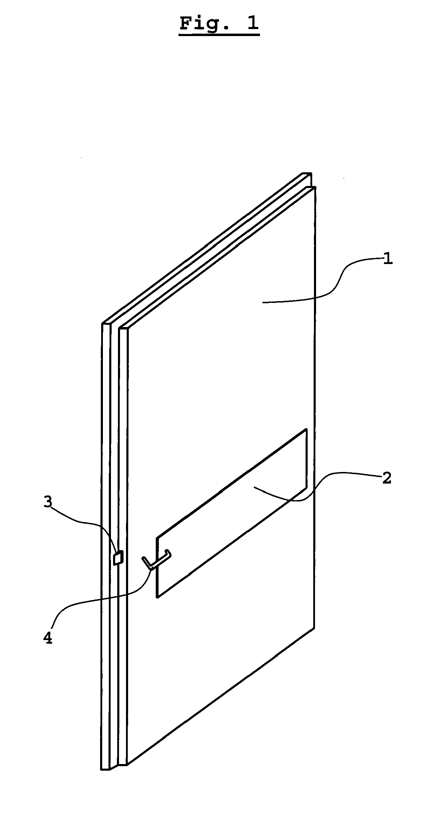

Gemäß Fig. 1 ist die Sensorfolie 2 an jener Seite des Türblattes 1 angeordnet, welche bei der Öffnungsbewegung hinten liegt. Im Unterschied zu den vorbekannten Panikbalken etc. besteht die Sensorfolie nicht aus starren Teilen, sondern aus mehreren Schichten flexiblen flächigen Materials. Ihre Gesamtstärke ist im Normalfall geringer als 1 mm. Für sehr robuste Ausführungsformen kann sie aber auch mit stärkeren Schichten ausgestattet sein, sodass ihre Gesamtstärke auch 2 bis 3 mm betragen kann. Sensorfolien welche für den vorliegenden, erfindungsgemäßen Einsatzfall an Türen geeignet sind, sind für andere technische Anwendungen schon massenhaft in Einsatz. Beispiele dafür sind Schaltfolien an Tastaturen und Geräteeingabeflächen, Touchpads, Touchscreens etc. Beispiel dafür ist im Dokument US 6 433 292 B1 gezeigt.

Ohne Anspruch auf Vollständigkeit seien an möglichen Funktionsprinzipien für die Sensorfolie beispielhaft kurz skizziert:
Ohmsche Funktion: Der Schichtaufbau weist zwei elektrisch leitende Schichten (bzw. zwei Schichten die durch elektrische Leiter durchzogen sind) und elektrisch isolierende, dazwischen liegende lokale Abstandshalter oder eine elektrisch isolierende netzartige Zwischenlage auf. Über die elektrisch isolierenden Teile sind die elektrisch leitenden Schichten mechanisch verbunden. Durch lokalen Druck ist eine leitende Schicht so weit zur anderen leitenden Schicht hin verformbar, dass sie diese andere Schicht berührt, womit ein Stromkreis geschlossen wird.

Kapazitive Funktion Variante 1: Der Schichtaufbau weist zwei elektrisch leitende Schichten und einen dazwischen liegende dielektrische Schicht auf. Durch Druck auf eine leitende Schicht wird ihr Abstand zur zweiten Schicht verringert, wodurch die elektrische Kapazität der Gesamtanordnung verändert wird. Diese Veränderung wird messtechnisch erfasst und für das Auslösen eines Schaltimpulses verwendet.

Kapazitive Funktion Variante 2: Der Schichtaufbau weist nur eine elektrisch leitende Schicht auf, deren Kapazität gegenüber der Umgebung gemessen wird, typischerweise mit Hilfe einer Schwingkreisschaltung. Bein Annäherung eines Körpers wie beispielsweis einer Hand eines Menschen an die elektrisch leitende Schicht (welche durch eine Isolierschicht geschützt ist) wird diese Kapazität verändert. Diese Veränderung wird messtechnisch erfasst und für das Auslösen eines Schaltimpulses verwendet. Dieses Messprinzip ist auch anwendbar, wenn die elektrisch leitende Schicht im Inneren des Türblattes angeordnet ist. In einer vorteilhaften Ausführungsvariante ist die elektrisch leitende Schicht durch eine elastische Schicht abgedeckt, und die Empfindlichkeit gegen Annäherung ist so eingestellt, dass die Annäherung soweit erfolgen muss, dass die elastische Schicht berührt und zumindest leicht verformt werden muss um einen Schaltimpuls auszulösen. Damit kann gegenüber einer rein berührungslosen Auslösemöglichkeit - welche an sich problemlos realisierbar ist - die Gefahr von ungewollten Auslösungen vermieden werden.

Optische Funktion: Der Schichtaufbau weist eine als optischer Wellenleiter wirkende Schicht auf, in welche Licht von einer Lichtquelle aus eingekoppelt wird und sich in ihr durch Totalreflexion ausbreitet. An mehreren optoelektronischen Sensoren (z.B. Photodioden) wird Licht von der leitenden Schicht ausgekoppelt und in Abhängigkeit von der Intensität des Lichtes ein elektrisches Signal generiert. Durch lokalen Druck auf die wellenleitende Schicht wird die Wellenleitung von Licht gestört, sodass Licht ausgekoppelt wird. Das "Stören" kann durch Krümmen der wellenleitenden Schicht oder durch Kontaktieren mit einer anderen, ansonsten nicht in Kontakt befindlichen Schicht mit ähnlicher optischer Dichte, oder durch Auskopplung in den berührenden Körper selbst geschehen. Die damit zumindest lokal verringerte Lichtintensität wird über die optoelektronischen Sensoren messtechnisch erfasst und für das Auslösen eines Schaltimpulses verwendet.

Bei allen genannten Funktionsprinzipien ist empfehlenswert, die Gesamtfläche der Sensorfolie elektrisch nicht als einzige große Sensorfläche auszuführen, sondern als einzelne, benachbart zueinander angeordnete, bezüglich ihrer Funktion unabhängig voneinander funktionierende, kleinere Sensorflächen. Damit können Sensibilität und Robustheit verbessert werden und unter Hinzuziehung einer "intelligenten" Steuerung kann darauf rückgeschlossen werden, wodurch ggf. die Sensorfolie berührt wird, bzw. wodurch auf sie gedrückt wird. Damit können Fehlauslösungen der Öffnungsfunktion besser verhindert werden.

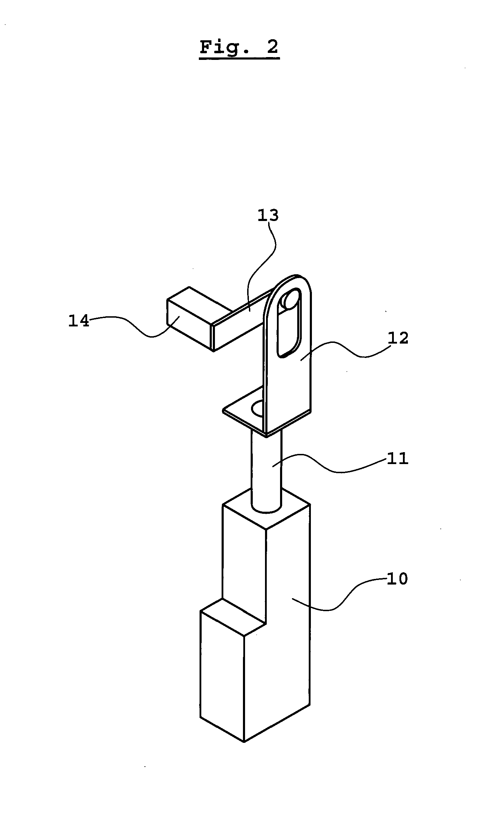

Fig. 2 zeigt eine vorteilhafte Ausführung eines elektromechanischen Antriebes, wie er an einer erfindungsgemäßen Tür eingebaut sein kann.

Der Antrieb besteht aus einem elektrischen Linearmotor 10 und mit dessen Anker 11 mechanisch verketteten, mechanischen Übertragungsteilen 12, 13, 14. Bei Stromfluss durch den Linearmotor 10 wird bestimmungsgemäß dessen Anker 11 in seiner Längsrichtung bewegt. Diese Bewegung wird über die mechanischen Übertragungsteile 12, 13 in eine Drehbewegung des Vierkantprofilteils 14 um seine Längsachse übersetzt.

Bestimmungsgemäß steckt der Vierkantprofilteil 14 wie die Verlängerung einer üblichen Türschnalle im Vierkantloch der "Nuss" (nicht dargestellt), des Türschlosses. Durch Drehen dieser "Nuss" wird beispielsweise der horizontal verschiebbare Riegel 3 (Fig. 1) vor- oder zurückbewegt und damit das Türblatt bezüglich Schwenkbewegung gehalten oder freigegeben. In einem anderen Anwendungsfall können auch vertikale Riegelstangen, durch welche ein Türblatt am oberen Rahmenteil und am Boden gegen Schwenkbewegung verankerbar ist, damit bewegt werden.

Die in Fig. 2 gezeigte Bauweise kann durch die Verwendung eines elektrischen Linearantriebes 10 so schmal ausgeführt werden, dass sie im Türblatt untergebracht sein kann. Bevorzugt ist der elektromechanische Antrieb im Türblatt an der Riegelseite in einer stirnseitigen Ausfräsung angebracht. Diese Ausfräsung kann gleich oder ähnlich, wie eine übliche Schlossausfräsung ausgebildet und hergestellt sein.

Weiter bevorzugt ist der elektrische Linearantrieb 10 ein elektrischer Linearmotor, also ein Elektromotor, bei welchem die elektrische Energie ohne Umweg über einen drehenden Anker direkt in lineare Bewegung eines Ankers umgewandelt wird. Am vorliegenden Anwendungsfall ist an derartige Motoren besonders vorteilhaft, dass sie bezüglich der zur Bewegungsrichtung des Ankers normalen Richtungen besonders schlank ausgeführt werden können, womit sie besonders leicht im Türblatt angeordnet werden können. Durch die Übersetzung der linearen Bewegung des Ankers 11 in eine relativ kleine Schwenkbewegung des Vierkantprofilteils 14 kann der Problematik bestens gerecht werden, dass elektrische Linearmotoren problemlos für große Hübe, nicht aber so problemlos für große Kräfte ausgelegt werden können.

Weitere erforderliche elektrischen Teile wie Steuerung, Energieversorgung, Akkumulator sind bevorzugt am oder im Türrahmen, oder in einer im Nahbereich des Türrahmens in der angrenzenden Mauer angeordneten Dose untergebracht. Für die erforderlichen Leitungs-und Steckverbindungen zwischen Türrahmen und Türblatt und innerhalb des Türblattes gibt es gemäß dem Stand der Technik schon eine Fülle von bekannten Bauweisen, weshalb hier nicht weiter darauf eingegangen wird.

Die Sensorfolie 2 kann oberflächlich mit einer Signalinformation versehen sein, durch welche klar wird, dass man auf sie drücken muss, damit sich die Tür öffnet. Die Sensorfolie kann sich auch über größere Flächenbereiche des Türblattes als in Fig. 1 dargestellt erstrecken und sie braucht nicht notwendigerweise rechteckförmig zugeschnitten zu sein.

Es ist auch möglich, die Sensorfolie 2 am Grund einer flachen Vertiefung des Türblattes anzubringen, sodass sie überhaupt nicht vorsteht.

## Patentansprüche

1. Paniktür, welche als Drehflügeltür ausgeführt ist, welche durch eine in Fluchtrichtung wirkende Druckkraft auf das Türblatt entriegelbar ist und nach dem Entriegeln in Fluchtrichtung aufschwenken kann, wozu das Türblatt an der Seite, welche beim Aufschwenken hinten liegt, mit einem Sensor ausgestattet ist, durch welchen detektierbar ist, dass auf diese Seite des Türblatts eine Druckkraft ausgeübt wird und wozu ein zwischen Türblatt und Türrahmen wirkender Riegel maschinell angetriebenen aus der gesperrten Stellung heraus bewegbar ist,
**dadurch gekennzeichnet, dass**
der Sensor eine aus mehreren Schichten flexiblen flächigen Materials aufgebaute Sensorfolie (2) ist, welche bei Druck
und/oder Berührung ein elektrisches Signal generiert.

2. Paniktür nach Anspruch 1, **dadurch gekennzeichnet dass** der Antrieb für den Riegel (3) ein elektrischer Linearantrieb (10) ist, welcher in einer Ausnehmung des Türblattes 1 angeordnet ist.

3. Paniktür nach Anspruch 2, **dadurch gekennzeichnet, dass** ein mit seiner Längsrichtung horizontal, normal zur Ebene des Türblattes angeordneter, mit dem Vierkantloch der Nuss eines Türschlosses in Eingriff befindlicher Vierkantprofilteil (14), durch den elektrische Linearantrieb (10) zu Drehbewegung um seine Längsachse antreibbar ist.

4. Paniktür nach Anspruch 2 oder Anspruch 3, **dadurch gekennzeichnet, dass** der elektrische Linearantrieb (10) ein elektrischer Linearmotor ist.

5. Paniktür nach einem der bisherigen Ansprüche, **dadurch gekennzeichnet, dass** die Sensorfolie (2) am Grund einer flachen Vertiefung des Türblattes (1) angebracht ist.

## Claims

1. Panic exit door, which is rendered as a swing door, which can be unlatched by exerting pressure on the door panel in the direction of escape and, following release of the latch, can swing open in the direction of escape, for which purpose the door panel is equipped with a sensor located on the reverse when swung open, which makes it possible to detect that pressure is being exerted on this side of the door panel and for which purpose a latch that operates between the door panel and the door frame, being mechanically powered, can be moved from the locked position,
**characterised by** the fact that
the sensor is a sensor foil (2) made from multiple layers of flexible, flat material, which generates an electrical signal upon pressure and/or contact.

2. Panic exit door in accordance with Claim 1, **characterised by** the fact that the drive for the latch (3) is an electrical, linear drive (10), which is positioned in a recess of the door panel (1).

3. Panic exit door in accordance with Claim 2, **characterised by** the fact that a square profile part (14), positioned such that its length is horizontally aligned as standard to the level of the door panel, and situated in the mesh by means of the square hole of the nut of a door lock, can be powered by the electrical linear drive (10) so as to pivot about its longitudinal axis.

4. Panic exit door in accordance with Claim 2 or Claim 3, **characterised by** the fact that the electrical linear drive (10) is an electrical linear motor.

5. Panic exit door in accordance with the aforestated Claims, **characterised by** the fact that the sensor foil (2) is mounted on the base of a flat recess of the door panel (1).

## Revendications

1. Porte anti-panique réalisée sous la forme d'une porte battante qui se déverrouille lorsqu'une pression est exercée sur le vantail de porte dans le sens d'évacuation et qui s'ouvre dans le sens d'évacuation après le déverrouillage, le vantail de porte étant à cet effet équipé, sur le côté arrière lors de l'ouverture, d'un capteur qui permet de détecter une pression exercée sur ce côté de la porte, ainsi que d'un pêne agissant entre le vantail de porte et le cadre de porte et pouvant être déplacé hors de la position de blocage par entraînement mécanique
**caractérisée en ce que**
le capteur est un film détecteur (2) composé de plusieurs couches de matériau plat flexible qui génère un signal électrique lors d'une pression et/ou d'un contact.

2. Porte anti-panique selon la revendication 1, **caractérisé en ce que** l'entraînement du pêne (3) est un entraînement linéaire électrique (10) qui est agencé dans un évidement du vantail de porte 1.

3. Porte anti-panique selon la revendication 2, **caractérisée en ce qu'**une pièce au profil carré (14) agencée avec sa longueur horizontalement par rapport au plan du vantail de porte et en prise avec le trou carré d'une serrure peut être entraînée en rotation autour de son axe longitudinal par l'entraînement linéaire électrique (10).

4. Porte anti-panique selon la revendication 2 ou 3, **caractérisée en ce que** l'entraînement linéaire électrique (10) est un moteur linéaire électrique.

5. Porte anti-panique selon l'une des revendications précédentes, **caractérisée en ce que** le film détecteur (2) est fixé au fond d'un évidement plat du vantail de porte (1).
